Europäisches Patentamt

(19) European Patent Office

Office européen des brevets

(11) Publication number: **0 121 271**
**B1**

## (12) EUROPEAN PATENT SPECIFICATION

(45) Date of publication of patent specification: **01.06.88**

(21) Application number: **84200215.6**

(22) Date of filing: **17.02.84**

(51) Int. Cl.⁴: **H 01 L 43/08, H 01 F 1/34**

(54) Electronic device.

(30) Priority: **17.02.83 NL 8300602**

(43) Date of publication of application:
**10.10.84 Bulletin 84/41**

(45) Publication of the grant of the patent:
**01.06.88 Bulletin 88/22**

(84) Designated Contracting States:
**AT BE CH DE FR GB IT LI LU NL SE**

(56) References cited:
**US-A-3 840 865**
**US-A-3 972 035**
**SIEMENS FORSCHUNGS- UND
ENTWICKLUNGSBERICHTE, vol. 1, no. 4, 1972,
pp. 369-375, Springer-Verlag (DE);
W.LUGSCHNEIDER et al.: "Magnetic
semiconductors"**
**LANDOLT-BÖRNSTEIN: "Zahlenwerk und
Funktionen aus Physik, Chemie, Astronomie,
Geophysik und Technik", 6th edition, vol. II, pp.
3/75-3/76; "Eigenschaften der Materie in ihren
Aggregatzuständen"; part 9, "Magnetische
Eigenschaften I"**
**Castellitz, L. Monatshefte Chem. 82, 1951, pp.
1959ff**

(73) Proprietor: **Stichting Katholieke Universiteit**
**Toernooiveld 1**
**NL-6525 ED Nijmegen (NL)**
(73) Proprietor: **Stichting voor Fundamenteel**
**Onderzoek der Materie**
**Van Vollenhovenlaan 661**
**NL-3527 JP Utrecht (NL)**

(72) Inventor: **de Groot, Robert Aart**
**Weezenhof 3431**
**NL-6536 GN Nijmegen (NL)**
Inventor: **Janner, Aloisio Giuseppe**
**Merellaan 15**
**NL-6581 CH Malden (NL)**
Inventor: **Mueller, Fred Michael**
**de Hazelaar 17**
**NL-6584 CV Molenhoek (NL)**

(74) Representative: **Urbanus, Henricus Maria, Ir.**
**et al**
**c/o Vereenigde Octrooibureaux Nieuwe**
**Parklaan 107**
**NL-2587 BP 's-Gravenhage (NL)**

Courier Press, Leamington Spa, England.

## Description

This invention relates to an electronic device comprising a plurality of layers of which at least one consists of a crystalline material, and including means for injecting electrons into at least one of the layers and for removing electrons from at least one other layer, and means for magnetizing said at least one layer of a crystalline material.

Electronic devices of this type are known, for instance from US—A—3,840,865. In said publication an electronic device, comprising at least three layers, is described in which (column 7, lines 7 ff) a central layer of crystalline magnetic semiconductor material is incorporated between two conducting layers. The device described is a tunnel junction device for detecting magnetic domains in a magnetic sheet. The crystalline material in the known device is magnetized to provoke a splitting of the conduction band for spin-up electrons and for spin-down electrons.

As is well-known, electrons not only have an electric charge, but also a magnetic moment, the so-called spin. The electric charge and the spin affect the physical characteristics of a material so drastically that they serve as a basis for the classification of materials. Thus, according to the electrical conductivity, we distinguish the metals (conductors), the semi-conductors and the insulators. By means of the magnetic moment, a classification is made by magnetic behaviour. Thus there are distinguished the ferromagnetic, anti-ferromagnetic, ferrimagnetic and non-magnetic materials. The electrical and magnetic classes can be combined with each other. Thus it is possible to speak of ferromagnetic metals (an example being iron), non-magnetic insulators (one example being glass), anti-ferromagnetic semi-conductors (for example MnTe, etc.) The crystalline material in the known device is a magnetic semiconductor.

It is an object of the present invention to provide an electronic device in which a material is used which, according to the above classification, can be characterized as a semi-metallic or half-metallic ferromagnetic or ferrimagnetic material. This object is reached by an electronic device in which the at least one layer of a crystalline material consists of a material in one direction of magnetic polarization exhibits all properties of a metal as regards the transport of electrons with a given direction of spin, while for electrons of opposite magnetic spin the material exhibits all properties of a semi-conductive material or an insulator, whereas one layer of the device is a layer in which direction of spin of electrons moving therethrough may be affected.

The use in the device according to the invention of a material that can be classified as semi-metallic ferromagnetic or ferrimagnetic material, opens up a route to a wholly new class of electronic devices.

As a layer of the material mentioned only conducts for example electrons with one specific direction of spin, such a layer can be used as a filter to produce polarized electrons. Thus for example, the device according to the invention can be applied as a polarizer or as an analyzer for such polarized particles in analogy to a nicol or polaroid filter for light.

Suitably, in the device according to the invention, at least one of the elements constituting the material of the at least one crystalline layer is a magnetic atom, with the crystal structure being such that, at that position, it does not exhibit inversion symmetry. In this embodiment, the magnetic atom is preferably manganese.

Preferably, in the device according to the invention, the crystal structure of the material of the at least one layer of crystalline material is a known per sé $C1_b$-Heusler structure that can be described as space group $F \bar{4} 3 m(T_d^2)$ (number 216 in the International Tables for X-ray Diffraction), and in which the a-positions (0,0,0) are occupied by an element from the third part of Group VIII of the Periodic Table (Ni, Pd, Pt), the b-positions $(\frac{1}{2}, \frac{1}{2}, \frac{1}{2})$ are unoccupied, the c-positions $(\frac{1}{4}, \frac{1}{4}, \frac{1}{4})$ are occupied by a magnetic element, and the d-positions $(\frac{3}{4}, \frac{3}{4}, \frac{3}{4})$ are occupied by an element of Group Va of the Periodic Table.

A highly suitable material of this preferred type is one in which the a-positions are occupied by nickel atoms, the c-positions by manganese atoms, and the d-positions by antimony atoms.

It has to be mentioned here that the material described hereinabove as having a known per sé $C1_b$-Heusler structure is known from e.g. Landolt-Börnstein: "Zahlenwerk und Funktionen aus Physik, Chemie, Astronomie, Geophysik und Technik", 6th Edition, Vol. II, pages 3—75 and 3—76. A general description of the system nickel-manganeses-antimony is given by L. Castellitz in Monatshefte für Chemie 82 (1951) pages 1059—1085. None of these references indicate or even suggest that the material concerned has such characteristics that in one direction of magnetic polarization all properties of a metal as regards the transport of electrons with a given direction of spin and for electrons of opposite magnetic spin all properties of a semiconductor or insulator is exhibited. The references mentioned do not suggest to incorporate the material disclosed in an electronic device comprising a plurality of layers.

The device of the invention can perform various functions. In a preferred embodiment the at least one layer of a crystalline material consists in essence of a single magnetic domain.

In an ideal layer or semi-metallic or half-metallic ferromagnetic or ferrimagnetic material in the device according to the invention, electrical conduction takes place exclusively by charge carriers with one specific spin orientation relative to the direction of magnetization of the material. Accordingly, affecting the spin orientation of the charge carriers from the outside has a direct effect on the electrical conduction. Using this aspect, devices can be made which amplify and/or switch current. Viewed in this way, such devices can be regarded as analogues of a transistor.

In the spin affecting zone of the device according to the invention, there is an interaction between the electron spin of the charge carriers and an external influence. Such an external influence may be an electrical, a magnetic, or an electromagnetic vibration (light or micro-wave). The external influence may even be a mechanical vibration, such as sound, while influencing by temperature is among the possibilities.

A substantial advantage of the device according to the invention is that the speed of operation is equal to the speed with which basic physical phenomena take place. Influencing the spin orientation of a charge carrier, for example, reversing the spin orientation of an electron, takes place at a speed of $10^{-11}$ second. This, then is also the order of velocity at which a device according to the invention can operate, which is a factor of 100 faster than devices hitherto known.

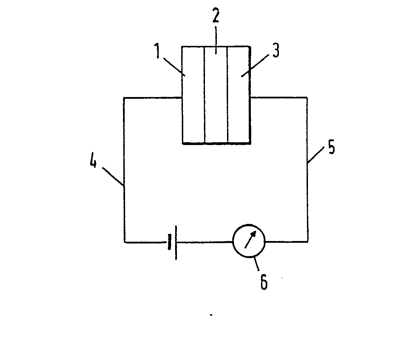

The invention is illustrated with reference to the accompanying drawing, in which the single figure is a diagrammatic illustration, by way of example, of one embodiment of a device according to the invention.

The device, shown diagrammatically, consists in essence of three layers. Layer 1 consists of the semi-metallic ferromagnetic or ferrimagnetic material according to the invention, for example, Ni Mn Sb, magnetized in one direction. Layer 2 consists of a suitable material in which the spin orientation of charge carriers moving therein can be influenced. Examples of such materials are the rare earth metals and the so-called transition metals. Layer 3 consists of the same material as layer 1. Layers 1 and 3 may be very thin, so long as a homogeneous magnetizable layer is available. A thickness in order of 100 atoms is already sufficient.

Connected to layer 1 is a conductor 4 supplying charge carriers to the device, and connected to layer 3 is a conductor 5 for the removal of charge carriers.

Assuming that layers 1 and 3 are both in such a state as to pass charge carriers with an upward spin ("spin-up") only, the device operates as a conductor for such charge carriers. Charge carriers with a downward spin ("spin-down") are not passed, because layers 1 and 3 operate as insulators for such charge carriers. Owing to the state of layer 1, only charge carriers with "spin-up" reach layer 2. If now, in layer 2, the spin orientation of the charge carriers is changed, for example owing to an external influence, and the spin is reversed, no more charge carriers enter conductor 5 via layer 3, because layer 3 only passes "spin-up" charge carriers. Accordingly, the device can serve both as a source of polarized charge carriers and for detecting an external influence. The passage of charge carriers by the device can be indicated, for example, by an ammeter 6 connected to conductor 5.

## Claims

1. An electronic device comprising a plurality of layers of which at least one consists of a crystalline material, and including means for injecting electrons into at least one of the layers and for removing electrons from at least one other layer, and means for magnetizing said at least one layer of a crystalline material, characterized in that said at least one layer of a crystalline material consists of a material that, in one direction of magnetic polarization, exhibits all properties of a metal as regards the transport of electrons with a given direction of spin, while for electrons of opposite magnetic spin the material exhibits all properties of a semi-conductive material or an insulator, and that one layer is a layer in which the direction of spin of electrons moving therethrough may be affected.

2. A device according to claim 1, characterized in that at least one of the elements constituting the material of the at least one layer of crystalline material is a magnetic atom, with the crystal structure being such that, at that position, it does not exhibit inversion symmetry.

3. A device according to claim 2, characterized in that said magnetic atom is manganese.

4. A device according to claims 1—3, characterized in that the crystal structure of the material of the at least one layer of crystalline material is a known per sé $C1_b$-Heusler structure that can be described as space group $F\,\bar{4}\,3\,m$ ($T_d^2$) (number 216 in the International Tables for X-ray Diffraction), and in which the a-positions $(0, 0, 0)$ are occupied by an element from the third part of group VIII of the Periodic Table (Ni, Pd, Pt), the b-positions $(\frac{1}{2}, \frac{1}{2}, \frac{1}{2})$ are unoccupied, the c-positions $(\frac{1}{4}, \frac{1}{4}, \frac{1}{4})$ are occupied by a magnetic element, and the d-positions $(\frac{3}{4}, \frac{3}{4}, \frac{3}{4})$ are occupied by an element of Group Va of the Periodic Table.

5. A device according to claim 4, characterized in that the a-positions are occupied by nickel atoms, the c-positions by manganese atoms, and the d-positions by antimony atoms.

6. A device according to claims 1—5, characterized in that said at least one layer of a crystalline material essentially consists of a single magnetic domain.

## Patentansprüche

1. Elektronische Vorrichtung mit mehreren Schichten, von denen mindestens eine aus einem kristallinen Material besteht, und versehen mit Mitteln zum Injizieren von Elektronen in mindestens eine der Schichten und zum Entfernen von Elektronen aus mindestens einer anderen Schicht und mit Mitteln zum Magnetisieren der genannten mindestens einen Schicht aus kristallinem Material, dadurch gekennzeichnet, dass die genannte mindestens eine Schicht aus kristallinem Material aus einem Material besteht, das in einer Richtung der magnetischen Polarisierung alle Eigenschaften eines Metalls aufweist, was den Transport von Elektronen mit einer gegebenen Spinrichtung betrifft, während für Elektronen des entgegengesetzten magnetischen Spins das Material alle Eigenschaften eines Halbleitermaterials oder eines Insolators aufweist, und dass eine Schicht vorhanden ist, in der die Spinrichtung von sich durch diese hindurchbewegenden Elektronen beeinflusst werden kann.

2. Vorrichtung nach Anspruch 1, dadurch gekennzeichnet, dass mindestens eines der das Material der mindestens einen Schicht aus kristallinem Material bildenden Elemente ein magnetisches Atom ist, wobei die Kristallstruktur so beschaffen ist, dass es, auf dem Platz, keine Inversionssymmetrie aufweist.

3. Vorrichtung nach Anspruch 2, dadurch gekennzeichnet, dass das genannte magnetische Atom Mangan ist.

4. Vorrichtung nach Ansprüchen 1 bis 3, dadurch gekennzeichnet, dass die kristallstruktur des Materials der mindestens einen Schicht aus kristallinem Material eine an sich bekannte $C1_b$-Heusler-Struktur ist, die als Raumgruppe $F\bar{4}3m$ $(T_d^2)$ (Nr. 216 in den Internationalen Tavellen für Röntgen-Strahlbeugung) beschrieben werden kann, und in der die a-Plätze $(0, 0, 0)$ von einem Element aus dem 3. Teil der Gruppe VIII des Periodensystems (Ni, Pd, Pt) besetzt sind, die b-Plätze $(\frac{1}{2}, \frac{1}{2}, \frac{1}{2})$ unbesetzt sind, die c-Plätze $(\frac{1}{4}, \frac{1}{4}, \frac{1}{4})$ von einem magnetischen Element und die d-Plätze $(\frac{3}{4}, \frac{3}{4}, \frac{3}{4})$ von einem Element der Gruppe Va des Periodensystems besetzt sind.

5. Vorrichtung nach Anspruch 4, dadurch gekennzeichnet, dass die a-Plätze von Nickelatomen, die c-Plätze von Manganatomen und die d-Plätze von Antimonatomen besetzt sind.

6. Vorrichtung nach Ansprüchen 1 bis 5, dadurch gekennzeichnet, dass die genannte mindestens eine Schicht aus kristallinem Material im wesentlichen aus einem einzelnen magnetischen Bereich besteht.

**Revendications**

1. Un dispositif électronique comprenant une pluralité de couches, dont l'une se compose d'un matériau cristallin, et contenant des moyens pour injecter des électrons dans au moins une des couches et pour enlever des électrons d'au moins une autre couche, et des moyens pour magnétiser ladite au moins une couche de matériau cristallin, caractérisé en ce que ladite au moins une couche de matériau cristallin se compose d'un matériau qui, dans une direction de polarisation magnétique, montre toutes les caractéristiques d'un métal en ce qui concerne le transport d'électrons avec une certaine direction de spin, alors que pour les électrons de spin magnétique opposé, le matériau montre toutes les caractéristiques d'un matériau semi-conducteur ou d'un isolateur, et qu'une couche est une couche dans laquelle la direction de spin d'électrons la traversant peut être affectée.

2. Un dispositif selon la revendication 1, caractérisé en ce qu'au moins un des éléments composant le matériau d'au moins une couche de matériau cristallin est un atome magnétique, la structure cristalline étant telle que, dans cette position, elle ne montre pas de symétrie d'inversion.

3. Un dispositif selon la revendication 2, caractérisé en ce que ledit atome magnétique est manganèse.

4. Un dispositif selon la revendications 1—3, caractérisé en ce que le structure cristalline du matériau d'au moins une couche de matériau cristallin est une structure $C1_b$-Heusler connue en elle-même, qui peur être décrite comme groupe spatial $F\bar{4}3m$ $(T_d^2)$ (numéro 216 aux Tables Internationales pour Diffraction de rayons X), et dans laquelle les positions-a $(0, 0, 0)$ sont occupées par un élément de la troisième partie du Groupe VIII de la Table Périodique (Ni, Pd, Pt), les positions-b $(\frac{1}{2}, \frac{1}{2}, \frac{1}{2})$ sont inoccupées, les positions-c $(\frac{1}{4}, \frac{1}{4}, \frac{1}{4})$ sont occupées par un élément mangétique, et les positions-d $(\frac{3}{4}, \frac{3}{4}, \frac{3}{4})$ sont occupées par un élément du Groupe Va de la Table Périodique.

5. Un dispositif selon la revendication 4, caractérisé en ce que les positions-a sont occupées par des atomes de nickel, les positions-c par des atomes de manganèse, et les positions-d par des atomes d'antimoine.

6. Un dispositif selon les revendications 1—5, caractérisé en ce que ladite au moins une couche d'un matériau cristallin se compose essentiellement d'un seul domaine magnetique.